# EUROPÄISCHE PATENTSCHRIFT

(11) **EP 4 147 277 B1**
(45) Veröffentlichungstag und Bekanntmachung des Hinweises auf die Patenterteilung: **28.02.2024**
(21) Anmeldenummer: 21715183.6
(22) Anmeldetag: 22.03.2021
(51) Int. Cl.: H01L 31/0224, H01L 31/0745

(54) **RÜCKSEITENKONTAKTIERTE SOLARZELLE**
BACK-SIDE CONTACT SOLAR CELL
CELLULE SOLAIRE MISE EN CONTACT DU CÔTÉ ARRIÈRE

(30) Priorität: 04.05.2020 DE 102020111997
(43) Veröffentlichungstag der Anmeldung: 15.03.2023
(73) Patentinhaber: EnPV GmbH, 76131 Karlsruhe (DE)
(72) Erfinder: HOFFMANN, Erik, 70499 Stuttgart (DE); WERNER, Jürgen, 70197 Stuttgart (DE)
(74) Vertreter: DREISS Patentanwälte PartG mbB
(86) Internationale Anmeldenummer: PCT/EP2021/057244
(87) Internationale Veröffentlichungsnummer: WO 2021/223932

(56) Entgegenhaltungen:
- EP-A1- 2 804 219
- EP-A1- 2 955 760
- US-A1- 2014 096 821

## Beschreibung

Die Erfindung betrifft eine Solarzelle und ein Verfahren zum Herstellen einer Solarzelle.

Solarzellen dienen bekanntermaßen als photovoltaische Elemente zur Umwandlung von Licht in elektrische Energie. Ladungsträgerpaare, die bei Absorption von Licht in einem Halbleitersubstrat erzeugt werden, werden am Übergang zwischen einem Emitterbereich, der einen ersten Dotierungstyp, bspw. n-Typ oder p-Typ, (zur Erzeugung einer ersten Polarität) aufweist, und einem Basisbereich, der einen entgegengesetzten Dotierungstyp (zur Erzeugung einer entgegengesetzten Polarität) aufweist, getrennt. Über Emitterkontakte, die den Emitterbereich kontaktieren, und Basiskontakte, welche den Basisbereich kontaktieren, können die derart erzeugten und separierten Ladungsträgerpaare einem externen Stromkreis zugeführt werden.

Bekannt sind Solarzellen, bei denen Kontakte einer Polarität an der Vorderseite angeordnet sind und Kontakte der entgegengesetzten Polarität an der Rückseite angeordnet sind. Als Vorderseite wird die der Sonne zugewandten Seite bezeichnet, die Rückseite ist auf der abgewandten Seite. Um Verluste, welche aus Abschattung durch die Kontakte an der Vorderseite resultieren, zu minimieren, wurden Rückkontaktsolarzellen entwickelt, bei denen beide Kontakttypen, d.h. die Emitterkontakte und die Basiskontakte, an einer Rückseite des Halbleitersubstrats angeordnet sind.

Rückkontaktsolarzellen haben großes Potential für höhere Wirkungsgrade, da es auf der Vorderseite der Solarzellen zu keiner Abschattung kommt und die einfallende Strahlung somit mehr freie Ladungsträger erzeugt. Die Elektroden der beiden Polaritäten liegen nebeneinander angeordnet auf der Rückseite der Solarzelle. Die generierten Ladungsträger müssen somit auch lateral in der Solarzelle fließen. Um die Widerstandsverluste durch diesen lateralen Stromfluss zu minimieren und zu verhindern, dass die freien Ladungsträger rekombinieren, bevor sie die Elektroden erreichen, sollten die Elektroden der beiden Polaritäten möglichst nah aneinander liegen. Da die Elektroden je nach Polarität mit p- oder n-Typ Silizium verbunden sind, liegen auch die pn-Übergänge möglichst dicht beisammen. Die pn-Übergänge, feine, kammartige Strukturen mit einer Auflösung unter 500 pm, können z.B. mittels Laserbestrahlung realisiert werden. Bei diesem Prozess treibt ein gepulster Laserstrahl zwei unterschiedliche Dotierstoffe, z.B. Bor und Phosphor, durch zeitlich und örtlich getrenntes Aufschmelzen der Oberfläche lokal in das Silizium ein und erzeugt je nach Dotierstoff entweder eine hohe p-Typ oder n-Typ Dotierung. Solch feine Strukturen ermöglichen geringe interne Serienwiderstände und Wirkungsgrade η bis η = 24 %. Höhere Wirkungsgrade sind im Wesentlichen durch Rekombinationsmechanismen in der Basis als auch an den hochdotierten kontaktierten und nicht kontaktierten Oberflächen begrenzt. Die Rekombination in der Basis ist abhängig von der Waferqualität und kann nur wenig im weiteren Fertigungsprozess der Solarzelle beeinflusst werden. Die Rekombination an den hochdotieren n- und p-Typ Oberflächen ist im nicht kontaktierten Bereich bei einer guten Oberflächenpassvierung, wie z.B. mit amorphem hydrogenierten Silizium, durch Auger-Rekombination begrenzt, welche mit der Dotierstoffkonzentration im Silizium steigt. Im kontaktierten Bereich ist das Silizium in Kontakt mit einem Metall, was eine hohe Grenzflächenrekombination zur Folge hat. Im Solarzellenprozess lässt sich die Auger-Rekombination an den nicht kontaktierten Oberflächen reduzieren, wenn sich dort möglichst wenig Dotierstoff im Silizium befindet, während die Grenzflächenrekombination an den Metall/Silizium-Kontakten durch eine möglichst kleine Kontaktfläche reduziert werden kann. Allerdings hat eine einfache Reduzierung des Dotierstoffs und der Kontaktflächen eine Steigerung des Serienwiderstands zu Folge, der dann der limitierende Faktor für den Wirkungsgrad wird.

Aus diesem Grund werden passivierte oder auch selektive Kontakte verwendet. Die Metallelektroden sind dabei nicht direkt mit der kristallinen Basis elektrisch verbunden, sondern durch ein dünnes Tunneloxid getrennt, welches die Siliziumoberfläche passiviert aber gleichzeitig so dünn ist, dass die Elektronen bzw. von der Elektrode in den Halbleiter je nach Polarität durch das Oxid vom Halbleiter in die Elektrode tunneln können. Um die Elektronen zum Tunneln anzuregen, muss sich am Tunneloxid ein elektrisches Feld befinden. Das elektrische Feld kann durch ein hochdotiertes n- oder p-Typ Silizium auf dem Tunneloxid generiert werden. Da die Dotierung dieses Siliziums oberhalb des Tunneloxids zu einer Bandverbiegung in der Siliziumbasis unterhalb des Tunneloxids führt, ist eine höhere Dotierung der Siliziumbasis nicht mehr erforderlich. Am hochdotieren n-Typ Silizium treten nur Elektronen durch das Tunneloxid, auch Elektronenfluss genannt, während am hochdotierten p-Typ Silizium nur ein sogenannter Löcherfluss stattfindet: Elektronen treten aus dem hochdotierten p-Typ Silizium in die Siliziumbasis ein. Die Metallelektroden selbst stehen nur noch in elektrischem und mechanischem Kontakt zu dem hochdotierten n- oder p-Typ Silizium oberhalb des Tunneloxids. Die Selektivität der hochdotierten Siliziumbereiche in Kombination mit dem Tunneloxid sorgt, abhängig von der Dotierung, für den Transport fast ausschließlich einer Art der Ladungsträger an die Metall/Silizium-Kontaktflächen und minimiert die Grenzflächenrekombination. Die vorgestellte Struktur senkt weiter die Auger-Rekombination an der Oberfläche der Siliziumbasis zum Tunneloxid, da an dieser Grenzfläche keine hohe Dotierung für den pn-Übergang oder den ohmschen Kontakt zu der Basis erforderlich ist. Rückseitenkontaktsolarzellen mit passivierten Kontakten erreichten bisher einen Rekordwirkungsgrad von η = 26,7 %. Die Herstellung solcher Zellen ist bisher jedoch sehr aufwendig, da die beiden unterschiedlich dotieren selektiven Kontakte nur mit diversen aufwendigen Maskierungs- und Strukturierungsschritten aufgebracht werden können. Dabei muss auf eine hohe Präzision und feine Auflösung der Maskierung/Strukturierung geachtet werden. Der Abstand der selektiven Kontakte darf nicht zu groß und sollte die Diffusionslänge der freien Ladungsträger nicht übersteigen und auch nicht zu einem Anstieg des internen Serienwiderstands aufgrund des lateralen Stromflusses in der Basis führen. Herstellungsverfahren mit Maskierungsschritten sind beispielsweise bekannt aus der EP 2 955 760 A1, US 2014/096821 A1 und EP 2 804 219 A1.

Diese Nachteile werden durch ein erfindungsgemäßes Verfahren zum Herstellen einer Solarzelle und einer nach diesem Verfahren hergestellten, erfindungsgemäßen Solarzelle überwunden.

Erfindungsgemäß wird für eine rückseitenkontaktierte Solarzelle umfassend ein Halbleitersubstrat, insbesondere einen Siliziumwafer, umfassend eine der Sonne zugewandten Vorderseite und eine Rückseite, wobei die Solarzelle auf der Rückseite Elektroden einer ersten Polarität und Elektroden einen zweiten Polarität umfasst, wobei sich unter den Elektroden der ersten Polarität eine Tunnelschicht und eine hochdotierte Siliziumschicht befinden und die Elektroden der zweiten Polarität das Halbleitersubstrat in hochdotierten Basisbereichen direkt elektrisch und mechanisch kontaktieren, wobei die hochdotierten Basisbereiche selektiv überkompensierte Bereiche der hochdotierten Siliziumschicht umfassen.

Die hohe Dotierung der hochdotierten Basisbereiche ist für einen geringen Kontaktwiderstand erforderlich.

Gemäß einer Ausführungsform ist vorgesehen, dass ein nicht kontaktierter, niedrigdotierter Bereich die hochdotierte Siliziumschicht von dem Basisbereich trennt. In diesem nicht kontaktierten, passivierten Bereich kann eine niedrigere Dotierung als in dem kontaktierten hochdotierten Basisbereich von Vorteil sein.

Weitere Ausführungsformen betreffen ein Verfahren zum Herstellen einer rückseitenkontaktierten Solarzelle gemäß den vorstehend beschriebenen Ausführungsformen. Die Herstellung einer fein aufgelösten Strukturierung auf der Rückseite erfolgt maskenfrei. Sie wird durch lokale Laserbestrahlung realisiert. Das Verfahren wird im Folgenden beschriebenen.

Das Halbleitersubstrat, insbesondere der Siliziumwafer, der Solarzelle umfasst eine, insbesondere polierte oder texturierte, Rückseite und eine, insbesondere texturierte, Vorderseite. In einem ersten Schritt des Verfahrens wird auf einer Oberfläche der Rückseite oder auf einer Oberfläche der Vorderseite und einer Oberfläche der Rückseite eine Tunnelschicht, insbesondere umfassend Siliziumoxid, aufgebracht. Die Tunnelschicht umfasst eine Dicke von vorzugsweise maximal etwa vier Nanometer. Die Tunnelschicht wird beispielsweise in einem thermischen oder nasschemischen Prozess oder durch Deposition hergestellt.

Das Verfahren umfasst weiter einen Schritt zum Abscheiden einer, insbesondere vollflächigen, hochdotierten Siliziumschicht einer ersten Polarität auf der Tunnelschicht auf der Rückseite. Die Abscheidung der hochdotierten Siliziumschicht der ersten Polarität kann beispielsweise mittels plasmaunterstützter chemischer Gasphasenabscheidung, PECVD, atmosphärischer chemischer Gasphasenabscheidung, APCVD, chemischer Niederdruck-Gasphasenabscheidung (LPCVD) oder Kathodenzerstäubung erfolgen. Die hochdotierte Siliziumschicht der ersten Polarität weist eine Dicke von ca. 100 Nanometer bis 300 Nanometer auf.

Die Abscheidung der hochdotierten Siliziumschicht der ersten Polarität kann statt in einem auch in zwei Schritten erfolgen. Gemäß einer Ausführungsform umfasst das Abscheiden der hochdotierten Siliziumschicht der ersten Polarität das Abscheiden von undotiertem Silizium und anschließendes Einbringen eines Dotierstoffs. Das Einbringen des Dotierstoffes erfolgt beispielsweise mittels Ionenimplantation, Ofendiffusion oder Laserdiffusion. Bei dem Dotierstoff handelt es sich beispielweise um Bor, Aluminium oder Gallium.

Gemäß einer Ausführungsform ist vorgesehen, dass das Verfahren einen Schritt zum Entfernen der Tunnelschicht, insbesondere Siliziumdioxid, und/oder der hochdotierten Siliziumschicht der ersten Polarität von der Vorderseite umfasst. Die Tunnelschicht und/oder die hochdotierte Siliziumschicht der ersten Polarität kann vollflächig oder lokal weggeätzt werden.

Das Verfahren umfasst einen Schritt zum Anbringen einer Precursorschicht umfassend einen Dotierstoff einer zweiten Polarität, auf der hochdotierten Siliziumschicht der ersten Polarität auf der Rückseite.

Wenn es sich bei der hochdotierten Siliziumschicht der ersten Polarität um eine p-Typ Siliziumschicht handelt, handelt es sich bei dem Dotierstoff für das Dotieren des Siliziums gemäß der zweiten Polarität beispielsweise um Phosphor. Zum Aufbringen der Precursorschicht kann beispielsweise ein Ofendiffusionsprozess gefahren werden, bei dem Phosphorsilikatglas auf der hochdotierten p-Typ Siliziumschicht auf der Rückseite und auf der Vorderseite wächst. Der Ofendiffusionsprozess kann so gefahren werden, dass nach dem Ofendiffusionsprozess in dem Phosphorsilikatglas ein hoher Anteil an Phosphor enthalten ist. Während der Ofendiffusion diffundiert Phosphor in die Vorderseite der Solarzelle und dotiert die Oberfläche der Vorderseite zu n-Typ. Auf der Rückseite diffundiert das Phosphor ebenfalls in die hochdotierte p-Typ Siliziumschicht. Die Parameter der Ofendiffusion werden dabei so gewählt, dass die Dotierstoffkonzentration des Phosphors die Dotierstoff-konzentration von Bor in der p-Typ Siliziumschicht nicht übersteigt. Die Precursorschicht, z.B. Phosphorsilikatglas, kann auch mittels anderer Verfahren wie z.B. PECVD aufgebracht werden.

Während der Ofendiffusion diffundiert ein Teil des zweiten Dotierstoffes aus der Precursorschicht in die hochdotierte Siliziumschicht. Die Ofendiffusion wird so gefahren, dass die eindiffundierte Dotierstoffkonzentration des zweiten Dotierstoffes nicht die Dotierstoffkonzentration des ersten Dotierstoffes in der hochdotierten Siliziumschicht übersteigt. So wird während der Ofendiffusion verhindert, dass es zu einer Überkompensation des ersten Dotierstoffes kommt. Wenn es sich bei der hochdotierten Siliziumschicht der ersten Polarität um eine p-Typ Siliziumschicht und bei dem Dotierstoff der zweiten Polarität um Phosphor handelt, bleibt die hochdotierte p-Typ Siliziumschicht also weiterhin p-Typ dotiert. Dagegen liegt die Dotierstoffmenge des zweiten Dotierstoffes, die sich noch in der Precursorschicht befindet, über der Dotierstoffmenge des ersten Dotierstoffs in der hochdotierten Siliziumschicht. Das Verfahren umfasst einen Schritt zum Laserbestrahlen der Rückseite, zum Erzeugen von lokal hochdotierten Basisbereichen einer zweiten Polarität. Handelt es sich bei dem zuvor aufgebrachten Dotierstoff der zweiten Polarität um Phosphor, dient das Phosphorsilikatglas als Dotierquelle während der Laserbestrahlung für die Erzeugung von lokal hochdotierten n-Typ Basisbereichen. Die Energie der Laserstrahlung schmilzt das Phosphorsilikatglas, die hochdotierte p-Typ Siliziumschicht, die Tunnelschicht und die Oberfläche der Rückseite in selektierten Bereichen lokal auf. Die Dotierstoffe aus dem Phosphorsilikatglas und der hochdotierten p-Typ Siliziumschicht diffundieren in die Siliziumschmelze an der Oberfläche der Rückseite. Nach Abklingen der Laserstrahlung kühlt und erstarrt die Schmelze. Beide Dotierstoffe verbleiben im Silizium, wobei es zur Anreicherung eines oder beider Dotierstoffe an der Oberfläche kommen kann. Aufgrund der größeren Dotierstoffmenge des Dotierstoffes der zweiten Polarität in der Precursorschicht ist die Konzentration des zweiten Dotierstoffes in der erstarrten Siliziumoberfläche wesentlich höher als die Konzentration des ersten Dotierstoffes aus der hochdotierten p-Typ Siliziumschicht und führt so durch Überkompensation zu einer lokal hohen n-Typ Dotierung in den selektierten Bereichen. Durch geeignete Wahl der Laserparameter können in den selektierten Bereichen auch lokal selektiv unterschiedlich hochdotierte Abschnitte von n-Typ Silizium erzeugt werden.

Gemäß einer Ausführungsform ist vorgesehen, dass das Verfahren einen Schritt zum selektiven Entfernen der hochdotierten Siliziumschicht der ersten Polarität und/oder der Precursorschicht, umfasst. Durch das Entfernen der Schicht oder Schichtstapel in angrenzenden Bereichen unterschiedlicher Polarität wird der Kontakt der beiden unterschiedlich dotierten Bereiche unterbrochen und es kann verhindert werden, dass es zu hoher Rekombination oder Kurzschlüssen in den Kontaktbereichen kommen kann. Das selektive Entfernen der hochdotierten Siliziumschicht der ersten Polarität kann z.B. durch Laserbestrahlung, nasschemisches Ätzen oder eine Kombination beider Prozesse erfolgen. Das Entfernen der Precursorschicht, insbesondere Phosphorsilikatglas, kann beispielsweise durch nasschemisches Ätzen erfolgen. Wenn es sich bei der hochdotierten Siliziumschicht der ersten Polarität um eine p-Typ Siliziumschicht und bei dem Dotierstoff der zweiten Polarität um Phosphor handelt kann durch das Rückätzen einiger Nanometer der p-Typ Siliziumschicht ein Teil der Siliziumschicht mit hohem Phosphorgehalt entfernt und eine Zunahme des Schichtwiderstands der p-Typ Siliziumschicht durch Phosphordiffusion begrenzt werden.

Gemäß einer Ausführungsform ist vorgesehen, dass das Verfahren einen Schritt zum Aufbringen einer Passivierschicht auf der Oberfläche der Vorderseite und/oder Rückseite umfasst. Die Passivierschicht umfasst beispielsweise thermisch gewachsenes Siliziumdioxid, Siliziumnitrid, Aluminiumoxid oder einen Schichtstapel aus zwei oder mehreren dielektrischen Schichten. Dabei kann sich die Dicke, Brechungsindex und Zusammensetzung der Passivierschicht auf der Rückseite von der Dicke, Brechungsindex und Zusammensetzung der Passivierschicht auf der Vorderseite unterscheiden. Die Dicken der Passivierschichten sind vorteilhafterweise so optimiert, dass die Reflexion auf der Vorderseite verringert und auf der Rückseite erhöht wird.

Gemäß einer Ausführungsform ist vorgesehen, dass das Verfahren einen Schritt zum Aufbringen von Elektroden auf der Rückseite der Solarzelle umfasst. Das Aufbringen der Elektroden kann beispielsweise mittels Siebdruck, Aufdampfen, Sputtern oder galvanischer Abscheidung eines oder mehrerer Metallen oder anderer leitfähiger Schichten erfolgen. Die Elektroden können beispielsweise Silberpaste, Silber/Aluminium-Paste, Aluminiumpaste oder reines Aluminium, Kupfer, Zinn, Palladium, Silber, Titan, Nickel oder Schichtstapel oder Legierungen der genannten Metalle oder andere leitfähige Schichten, insbesondere leitfähige Polymere oder Oxide, oder eine Kombination solcher Schichten mit Metallen umfassen. Die Zusammensetzung und der Abscheidungsprozess der Elektroden kann sich bei beiden Polaritäten unterscheiden. Die Elektroden können, insbesondere in einem Hochtemperaturschritt nach dem Siebdrucken, lokal die Passivierschicht durchdringen und, je nach Polarität der Elektroden, entweder die hochdotierte p-Typ Siliziumschicht oder die hochdotierten Basisbereiche kontaktieren.

Gemäß einer Ausführungsform ist vorgesehen, dass das Verfahren einen Schritt zum selektiven Entfernen der Passivierschicht umfasst. Vor der Deposition der Elektroden kann die Passivierschicht lokal, z.B. durch Laserbestrahlung entfernt werden.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind.

In der Zeichnung zeigt:
Fig. 1 eine schematische Ansicht eines Ausschnitts einer erfindungsgemäßen Solarzelle, und
Fig. 2a bis 2h zeigen eine Solarzelle gemäß Figur 1 in verschiedenen Schritten eines Verfahrens zur Herstellung der Solarzelle.

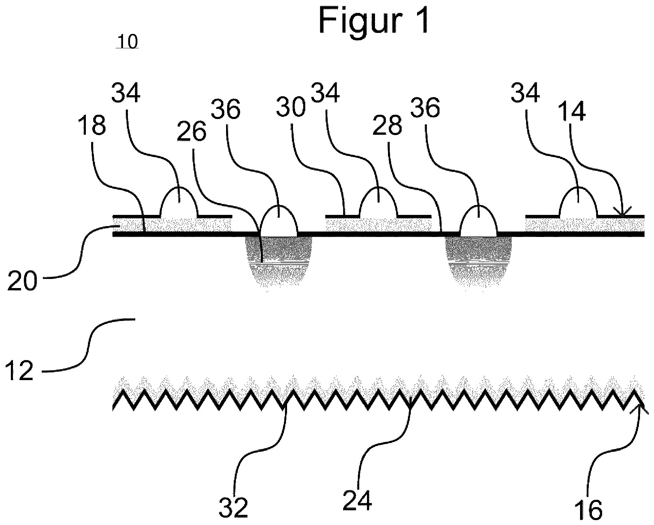

Figur 1 zeigt einen Ausschnitt einer Solarzelle 10 mit einem Halbleitersubstrat 12, insbesondere einem Siliziumwafer, einer Rückseite 14 und einer der Sonne zugewandten Vorderseite 16. Der Siliziumwafer 12 kann entweder n- oder p-Typ dotiert sein. Die Solarzelle 10 wird beispielhaft anhand einer n-Typ Dotierung des Siliziumwafers 12, der "Basis", erläutert.

Auf der Rückseite 14 ist eine polykristalline hochdotierte p-Typ Siliziumschicht 20 vorgesehen. Diese bildet eine erste Polarität auf der Rückseite 14. Im Bereich der hochdotierten p-Typ Siliziumschicht 20 passiviert eine Tunnelschicht 18, insbesondere umfassend Siliziumdioxid, 18 die Oberfläche des Siliziumwafers 12.

Die Solarzelle 10 umfasst auf der Rückseite 14 Elektroden 34 einer ersten Polarität und Elektroden 36 einer zweiten Polarität. Unter den Elektroden 34 der ersten Polarität befindet sich die Tunnelschicht 18 und die hochdotierte p-Typ Siliziumschicht 20. Die Elektroden 36 der zweiten Polarität kontaktierten das Halbleitersubstrat 12 direkt elektrisch und mechanisch. Die Elektroden 36 der zweiten Polarität kontaktieren das Halbleitersubstrat 12 gemäß der dargestellten Ausführungsform in hochdotierten Basisbereichen 26. Ein nicht kontaktierter Randbereich 28 trennt die hochdotierte p-Typ Siliziumschicht 20 und den hochdotierten n-Typ Basisbereich 26.

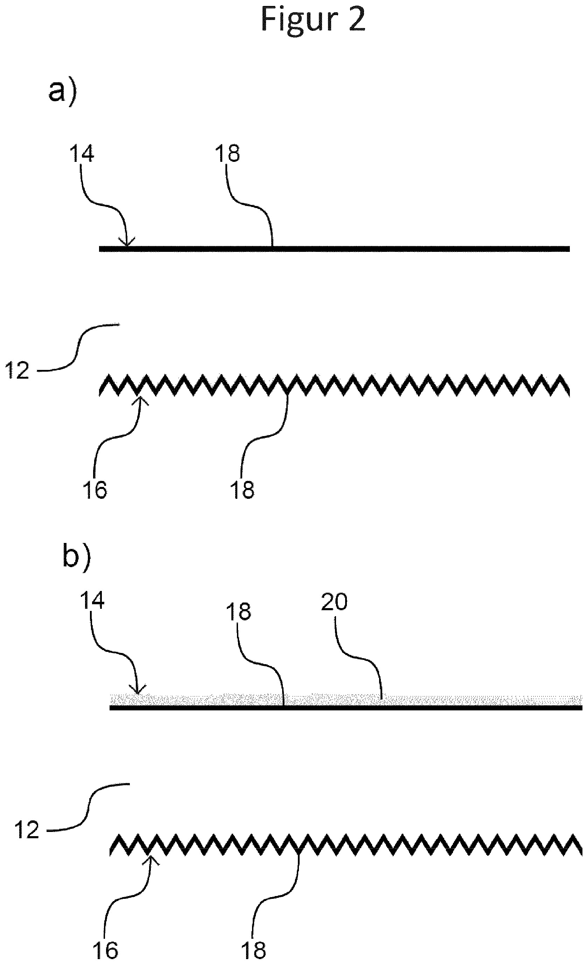

Der Herstellungsprozess der Solarzelle 10 wird im Weiteren anhand der Figuren 2a bis 2h erläutert. Die Figuren 2a bis 2h illustrieren den Prozessablauf für die maskenfreie Fertigung einer Solarzelle 10 mit einer einzigen Art von selektiven Kontakten. Als Ausgangsmaterials kann der Siliziumwafer 12 mit einer Vorderseite 14 und einer Rückseite 16 entweder n- oder p-Typ dotiert sein. Der Prozessablauf wird anhand einer n-Typ Dotierung des Wafers, der "Basis", erläutert.

Figur 2a zeigt den Siliziumwafer 12 mit einer polierten Rückseite 14 und einer texturierten Vorderseite 16. Auf beiden Oberflächen, oder vorzugsweise nur der Rückseite 14, wird eine Tunnelschicht 18, z.B. ein Siliziumdioxid, mit einer Dicke von vorzugsweise maximal etwa vier Nanometer, beispielsweise in einem thermischen oder nasschemischen Prozess oder durch Deposition, hergestellt.

In einem nächsten Schritt des Verfahrens wird eine, insbesondere vollflächige, hochdotierte Siliziumschicht 20 einer ersten Polarität auf der Tunnelschicht 18 auf der Rückseite 14 abgeschieden. Im Weiteren wird von einer p-Typ Dotierung als erste Polarität ausgegangen. Figur 2b zeigt die vollflächige Abscheidung der hochdotierten p-Typ Siliziumschicht 20 auf der Tunnelschicht 18 auf der Rückseite 14. Die Abscheidung der hochdotierten p-Typ Siliziumschicht 20 kann beispielsweise mittels plasmaunterstützter chemischer Gasphasenabscheidung, PECVD, atmosphärischer chemischer Gasphasenabscheidung, APCVD, chemischer Niederdruck-Gasphasenabscheidung (LPCVD) oder Kathodenzerstäubung erfolgen. Die hochdotierte p-Typ Siliziumschicht 20 weist eine Dicke von ca. 100 Nanometer bis 300 Nanometer auf.

Das Abscheiden der hochdotierten p-Typ Siliziumschicht 20 kann statt in einem auch in zwei Schritten erfolgen. In diesem Fall umfasst das Abscheiden der p-Typ Siliziumschicht 20 das Abscheiden von undotiertem Silizium und anschließendes Einbringen eines Dotierstoffs. Das Einbringen des Dotierstoffs erfolgt beispielsweise mittels Ionenimplantation, Ofendiffusion oder Laserdiffusion. Bei dem Dotierstoff handelt es sich beispielweise um Bor, Aluminium oder Gallium.

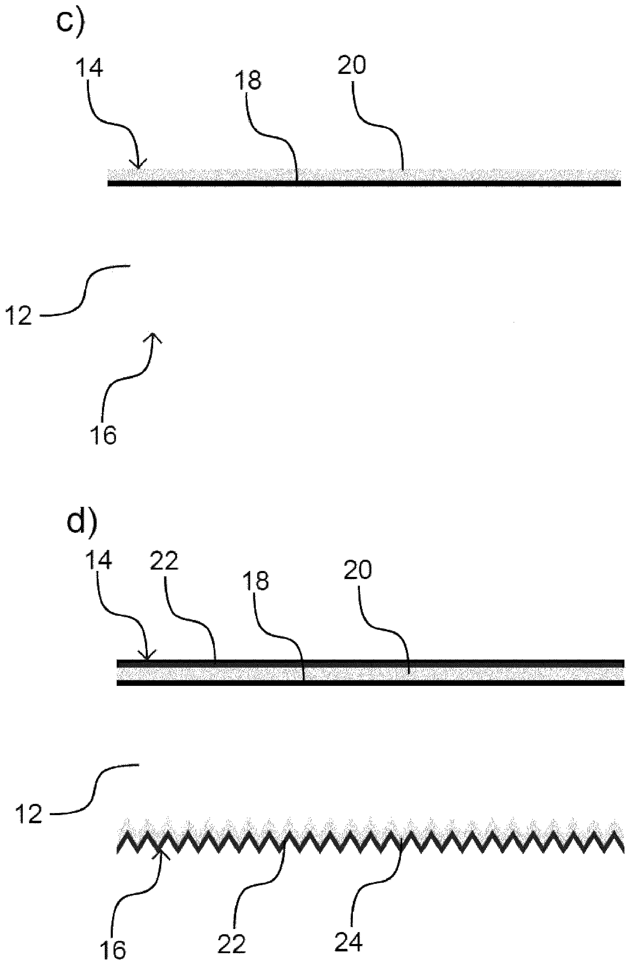

Wenn sich auf der Vorderseite 16 eine Tunnelschicht 18 und/oder eine, insbesondere unbeabsichtigt abgeschiedene, hochdotierte p-Typ Siliziumschicht 20 befindet, wird in einem nächsten Schritt des Verfahrens die Tunnelschicht 18, und/oder die hochdotierte p-Typ Siliziumschicht 20 von der Vorderseite 16 entfernt. Die Tunnelschicht 18 und/oder die hochdotierte p-Typ Siliziumschicht 20 kann vollflächig oder lokal weggeätzt werden. Dies ist in Figur 2c dargestellt. In einem nächsten Schritt des Verfahrens, der in Figur 2d dargestellt ist, wird eine Precursorschicht 22 umfassend einen Dotierstoff, insbesondere Phosphor, auf der hochdotierten Siliziumschicht 20 der ersten Polarität auf der Rückseite 14, angebracht. Gemäß der dargestellten Ausführungsform handelt es sich bei dem Dotierstoff der zweiten Polarität um Phosphor. Zum Anbringen der Precursorschicht 22 wird beispielsweise ein Ofendiffusionsprozess oder eine PECVD-Abscheidung gefahren, bei dem Phosphorsilikatglas 22 auf der hochdotierten p-Typ Siliziumschicht 20 auf der Rückseite 14 und auf der Vorderseite 16 wächst. Während der Ofendiffusion diffundiert Phosphor aus dem Phosphorsilikatglas 22 in die Vorderseite 16 der Solarzelle 10 und dotiert die Oberfläche der Vorderseite 16 zu n-Typ. Auf der Rückseite 14 diffundiert das Phosphor ebenfalls in die hochdotierte p-Typ Siliziumschicht 20. Der Ofendiffusionsprozess wird vorteilhafterweise so gefahren, dass nach dem Ofendiffusionsprozess in dem Phosphorsilikatglas 22 ein hoher Anteil an Phosphor enthalten ist. Eine Konzentration der Dotierstoffe in der hochdotierten p-Typ Siliziumschicht 20 und der Precursorschicht 22 ist so gewählt, dass nach der Ofendiffusion in der hochdotierten p-Typ Siliziumschicht 20 zum einen die Dotierstoffkonzentration des ersten Dotierstoffes höher ist als die Dotierstoffkonzentration des zweiten Dotierstoffes zum anderen aber in der Precursorschicht die Dotierstoffmenge des zweiten Dotierstoffes höher ist als die Dotierstoffmenge des ersten Dotierstoffes in der hochdotierten p-Typ Siliziumschicht 20. So wird verhindert, dass es während der Ofendiffusion zu einer Überkompensation des ersten Dotierstoffes kommt. Die hochdotierte p-Typ Siliziumschicht bleibt also weiterhin p-Typ dotiert. Für den folgenden Schritt der Laserbestrahlung ist auf diese Weise aber ausreichend Dotierstoff im Phosphorsilikatglas 22 vorhanden um während der Laserbestrahlung den Dotierstoff der ersten Polarität zu überkompensieren.

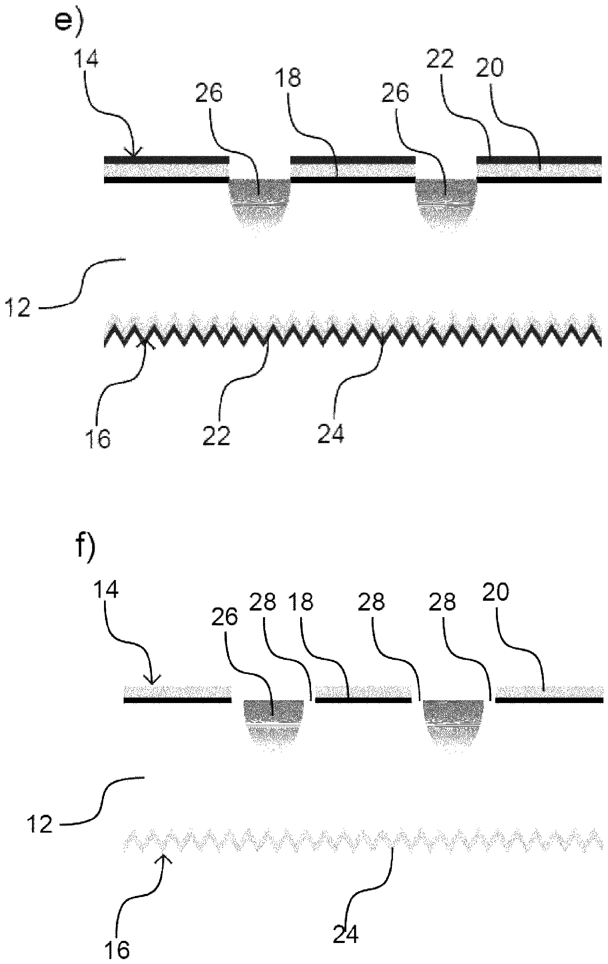

Das Verfahren umfasst einen Schritt zum Laserbestrahlen der Rückseite 14, zum Erzeugen von lokal hochdotierten n-Typ Basisbereichen 26. Figur 2e zeigt die Solarzelle 10 nach dem die Rückseite 14 lokal mit Laser bestrahlt wurde. Das Phosphorsilikatglas 22 dient als Dotierquelle während der Laserbestrahlung für die Erzeugung einer lokal hochdotierten n-Typ Basisoberfläche in den lokal hochdotierten n-Typ Basisbereichen 26. Die Energie der Laserstrahlung schmilzt das Phosphorsilikatglas 22, die hochdotierte p-Typ Siliziumschicht 20, die Tunnelschicht, nämlich das Siliziumdioxid 18 und die Oberfläche der Rückseite 14 lokal auf, so dass die lokal hochdotierten n-Typ Basisbereichen 26 entstehen. Die Dotierstoffe aus dem Phosphorsilikatglas 22 und der hochdotierten p-Typ Siliziumschicht 20 diffundieren in die Siliziumschmelze an der Oberfläche der Rückseite 14. Nach Abklingen der Laserstrahlung kühlt und erstarrt die Schmelze. Beide Dotierstoffe verbleiben im Silizium, wobei es zur Anreicherung eines oder beider Dotierstoffe an der Oberfläche kommen kann. Aufgrund der größeren Dotierstoffmenge des Dotierstoffes der zweiten Polarität im Phosphorsilikatglas 22 ist die Konzentration des zweiten Dotierstoffes in der erstarrten Siliziumoberfläche wesentlich höher als die Konzentration des ersten Dotierstoffes aus der hochdotierten p-Typ Siliziumschicht 20 und führt so durch Überkompensation zu einer lokalen hohen n-Typ Dotierung in lokal hochdotierten n-Typ Basisbereichen 26. Durch geeignete Wahl der Laserparameter können in den lokal hochdotierten n-Typ Basisbereichen 26 auch lokal selektiv unterschiedlich hochdotierte Abschnitte von n-Typ Silizium erzeugt werden.

Bei Rückkontaktsolarzellen mit selektiven Kontakten beider Polaritäten kann es zu hoher Rekombination kommen, wenn die beiden unterschiedlich dotierten Siliziumschichten sich kontaktieren. Daher umfasst das Verfahren einen Schritt zum selektiven Entfernen der hochdotierten Siliziumschicht 20 der ersten Polarität und/oder der Precursorschicht 22.

Figur 2f zeigt die Solarzelle 10 nach dem die hochdotierte p-Typ Siliziumschicht 20 in den Randbereichen 28 der lokal hochdotierten n-Typ Basisbereichen 26 entfernt wurde. Das Entfernen der p-Typ Siliziumschicht 20 in den Randbereichen 28 kann z.B. durch Laserbestrahlung, nasschemisches Ätzen oder eine Kombination beider Prozesse erfolgen. Weiter kann ein nasschemischer Prozess verwendet werden, um das Phosphorsilikatglas 22 von der hochdotierten p-Typ Siliziumschicht und der Vorderseite 16 der Solarzelle zu entfernen. Ein Rückätzen einiger Nanometer der hochdotierten p-Typ Siliziumschicht 20 kann eine Siliziumschicht mit hohem Phosphorgehalt entfernen und eine Zunahme eines Schichtwiderstands der hochdotierten p-Typ Siliziumschicht 20 durch Phosphordiffusion begrenzen.

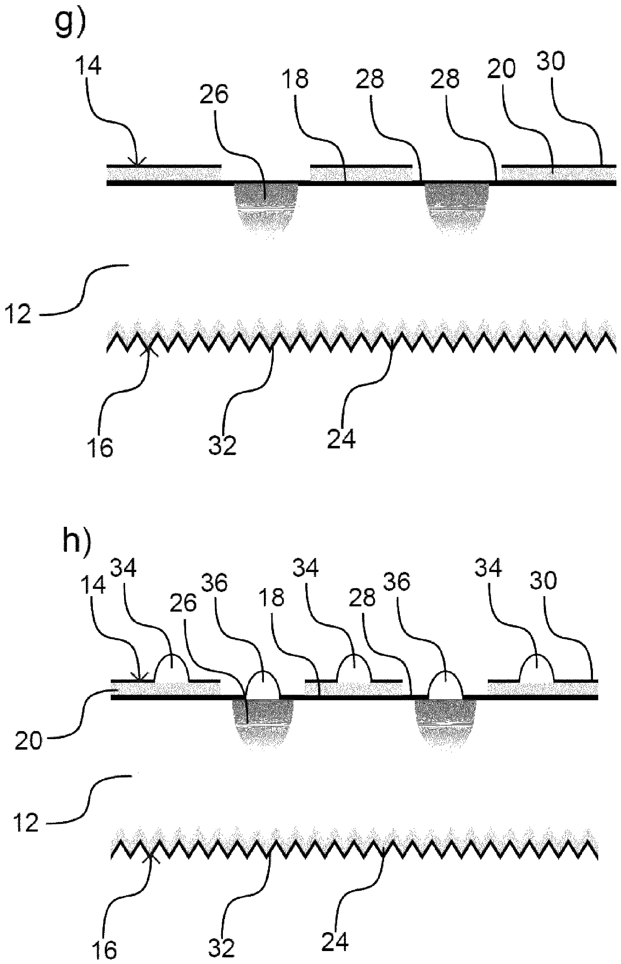

Figur 2g zeigt die Solarzelle 10 nach dem eine Passivierschicht 30, 32 auf der Oberfläche der Vorderseite 16 und/oder Rückseite 14 angebracht wurde. Die Passivierschicht 30, 32 umfasst beispielsweise thermisch gewachsenes Siliziumdioxid, Siliziumnitrid, Aluminiumoxid oder einen Schichtstapel aus zwei oder mehreren dielektrischen Schichten. Dabei kann sich die Dicke, Brechungsindex und Zusammensetzung der Passivierschicht 30 auf der Rückseite 14 von der Dicke, Brechungsindex und Zusammensetzung der Passivierschicht 32 auf der Vorderseite 16 unterscheiden. Die Dicken, Zusammensetzung und Brechungsindices der Passivierschichten 30, 32 sind vorteilhafterweise so optimiert, dass die Reflexion auf der Vorderseite 16 verringert und auf der Rückseite 14 erhöht wird.

Figur 2h zeigt die Solarzelle 10 nach dem Elektroden 34, 36 auf der Rückseite 14 der Solarzelle 10 aufgebracht wurden. Das Aufbringen der Elektroden 34, 36 kann beispielsweise mittels Siebdruck, Aufdampfen, Sputtern oder galvanischer Abscheidung eines oder mehrerer Metallen oder anderer leitfähiger Schichten erfolgen. Die Elektroden 34, 36 können beispielsweise Silberpaste, Silber/Aluminium-Paste, Aluminiumpaste oder reines Aluminium, Kupfer, Zinn, Palladium, Silber, Titan, Nickel oder Schichtstapel oder Legierungen der genannten Metalle oder andere leitfähige Schichten, insbesondere leitfähige Polymere oder Oxide, oder eine Kombination solcher Schichten mit Metallen umfassen. Die Zusammensetzung und der Abscheidungsprozess der Elektroden 34, 36 kann sich bei beiden Polaritäten unterscheiden. Die Elektroden 34, 36 können, insbesondere in einem Hochtemperaturschritt nach dem Siebdrucken, lokal die Passivierschicht durchdringen und, je nach Polarität der Elektroden, entweder die hochdotierte p-Typ Siliziumschicht 20 oder die lokal hochdotierten n-Typ Basisbereiche 26 kontaktieren.

Optional kann vor dem Aufbringen der Elektroden 34, 36 die Passivierschicht selektiv, beispielsweise durch Laserbestrahlung, entfernt werden, sodass die Elektroden die p-Typ Siliziumschicht 20 oder die lokal hochdotierten n-Typ Basisbereiche 26 direkt kontaktieren.

## Patentansprüche

1. Verfahren zum Herstellen einer rückseitenkontaktierten Solarzelle (10), wobei ein Halbleitersubstrat (12) der Solarzelle (10), eine, insbesondere polierte oder texturierte, Rückseite (14) und eine, insbesondere texturierte, Vorderseite (16) umfasst, wobei das Verfahren die folgenden Schritte umfasst: Aufbringen einer Tunnelschicht (18), insbesondere umfassend Siliziumdioxid, auf einer Oberfläche der Rückseite (14) oder auf einer Oberfläche der Vorderseite (16) und einer Oberfläche der Rückseite (14), und Abscheiden einer, insbesondere vollflächigen, hochdotierten Siliziumschicht (20) einer ersten Polarität auf der Tunnelschicht (18) auf der Rückseite (14), **dadurch gekennzeichnet, dass** das Verfahren weiter umfasst einen Schritt zum Anbringen einer Precursorschicht (22) umfassend einen Dotierstoff, insbesondere Phosphor, auf der hochdotierten Siliziumschicht (20) der ersten Polarität auf der Rückseite (14), wobei eine Konzentration der Dotierstoffe in der hochdotierten Siliziumschicht (20) der ersten Polarität und der Precursorschicht (22) so gewählt wird, dass eine Dotierstoffmenge des Dotierstoffs einer zweiten Polarität in der Precursorschicht (22) höher ist als die Dotierstoffmenge des Dotierstoffs der ersten Polarität in der hochdotierten Siliziumschicht (20) der ersten Polarität und dass das Verfahren einen Schritt zum Laserbestrahlen der Rückseite (14)zum Erzeugen von lokal hochdotierten Basisbereichen (26) umfasst, wobei der Dotierstoff der zweiten Polarität den Dotierstoff der ersten Polarität während der Laserbestrahlung überkompensiert und so durch Überkompensation die lokal hochdotierten Basisbereiche (26) erzeugt werden.

2. Verfahren nach Anspruch 1, **dadurch gekennzeichnet, dass** das Abscheiden der hochdotierten Siliziumschicht (20) der ersten Polarität das Abscheiden von undotiertem Silizium und anschließendes Einbringen eines Dotierstoffs umfasst.

3. Verfahren nach wenigstens einem der Ansprüche 1 bis 2, **dadurch gekennzeichnet, dass** das Verfahren einen Schritt zum Entfernen der Tunnelschicht (18), insbesondere Siliziumoxid, und/oder der hochdotierten Siliziumschicht (20) der ersten Polarität von der Vorderseite (16) umfasst.

4. Verfahren nach wenigstens einem der Ansprüche 1 bis 3, **dadurch gekennzeichnet, dass** das Verfahren einen Schritt zum Anbringen einer Precursorschicht (22) umfassend einen Dotierstoff, insbesondere Phosphor, auf der hochdotierten Siliziumschicht (20) der ersten Polarität auf der Vorderseite (16), umfasst.

5. Verfahren nach wenigstens einem der Ansprüche 1 bis 4, **dadurch gekennzeichnet, dass** das Verfahren einen Schritt zum selektiven Entfernen der hochdotierten Siliziumschicht (20) der ersten Polarität und/oder der Precursorschicht (22), umfasst.

6. Verfahren nach wenigstens einem der Ansprüche 1 bis 5, **dadurch gekennzeichnet, dass** das Verfahren einen Schritt zum Aufbringen einer Passivierschicht (30, 32) auf der Oberfläche der Vorderseite (16) und/oder Rückseite (14) umfasst.

7. Verfahren nach wenigstens einem der Ansprüche 1 bis 6, **dadurch gekennzeichnet, dass** das Verfahren einen Schritt zum Aufbringen von Elektroden (34, 36) auf der Rückseite (14) der Solarzelle (10) umfasst.

8. Verfahren nach wenigstens einem der Ansprüche 6 bis 7, **dadurch gekennzeichnet, dass** das Verfahren einen Schritt zum selektiven Entfernen der Passivierschicht (30, 32) umfasst.

9. Rückseitenkontaktierte Solarzelle (10), hergestellt gemäß einem Verfahren nach wenigstens einem der Ansprüche 1 bis 8, die Solarzelle (10) umfassend ein Halbleitersubstrat (12), insbesondere einen Siliziumwafer, umfassend eine Vorderseite (16) und eine Rückseite (14), wobei die Solarzelle (10) auf der Rückseite Elektroden (30) einer ersten Polarität und Elektroden (32) einen zweiten Polarität umfasst, wobei sich unter den Elektroden (34) einer ersten Polarität eine Tunnelschicht (18) und eine hochdotierte Siliziumschicht (20) befinden und die Elektroden (36) der zweiten Polarität das Halbleitersubstrat (12) in hochdotierten Basisbereichen (26) direkt elektrisch und mechanisch kontaktieren, **dadurch gekennzeichnet, dass** die hochdotierten Basisbereiche (26) selektiv überkompensierte Bereiche der hochdotierten Siliziumschicht (20) umfassen.

10. Solarzelle nach Anspruch 9, **dadurch gekennzeichnet, dass** ein nicht kontaktierter, niedrigdotierter Bereich (28) die hochdotierte Siliziumschicht (20) von dem Basisbereich (26) trennt.

## Claims

1. A method for producing a back-side contact solar cell (10), wherein a semiconductor substrate (12) of the solar cell (10) comprises a, in particular polished or textured, back side (14) and a, in particular textured, front side (16), wherein the method comprises the steps of: applying a tunnel layer (18), in particular comprising silicon dioxide, to a surface of the front side (16) and/or to a surface of the back side (14), and depositing a, in particular full-area, highly doped silicon layer (20) of a first polarity on the tunnel layer (18) on the back side (14), **characterized in that** the method further comprises a step of applying a precursor layer (22) comprising a dopant, in particular phosphorus, on the highly doped silicon layer (20) of the first polarity on the back side (14), wherein a concentration of the dopants in the highly doped silicon layer (20) of the first polarity and of the precursor layer (22) is selected such that an amount of the dopant of a second polarity in the precursor layer (22) is higher than the amount of the dopant of the first polarity in the highly doped silicon layer (20) of the first polarity, and **in that** the method comprises a step of laser irradiation of the back side (14), in particular for producing locally highly doped base regions (26).

2. The method according to claim 1, **characterized in that** the depositing of the highly doped silicon layer (20) of the first polarity comprises the depositing of undoped silicon and subsequent introduction of a dopant.

3. The method according to at least one of the claims 1 to 2, **characterized in that** the method comprises a step of removing the tunnel layer (18), in particular silicon oxide, and/or the highly doped silicon layer (20) of the first polarity from the front side (16).

4. The method according to at least one of the claims 1 to 3, **characterized in that** the method comprises a step of applying a precursor layer (22) comprising a dopant, in particular phosphorus, on the highly doped silicon layer (20) of the first polarity on the front side (16).

5. The method according to at least one of the claims 1 to 4, **characterized in that** the method comprises a step of selectively removing the highly doped silicon layer (20) of the first polarity and/or the precursor layer (22).

6. The method according to at least one of the claims 1 to 5, **characterized in that** the method comprises a step of applying a passivation layer (30, 32) to the surface of the front side (16) and/or back side (14).

7. The method according to at least one of the claims 1 to 6, **characterized in that** the method comprises a step of applying electrodes (34, 36) to the back side (14) of the solar cell (10).

8. The method according to at least one of the claims 6 to 7, **characterized in that** the method comprises a step of selectively removing the passivation layer (30, 32).

9. A back-side contact solar cell (10), produced according to a method according to at least one of the claims 1 to 8, the solar cell (10) comprising a semiconductor substrate (12), in particular a silicon wafer, comprising a front side (16) and a back side (14), wherein the solar cell (10) comprises, on the back side, electrodes (30) of a first polarity and electrodes (32) of a second polarity, wherein a tunnel layer (18) and a highly doped silicon layer (20) are positioned under the electrodes (34) of a first polarity, and the electrodes (36) of the second polarity make direct electrical and mechanical contact with the semiconductor substrate (12) in highly doped base regions (26), wherein the highly doped base regions (26) comprise selectively overcompensated regions of the highly doped silicon layer (20).

10. The solar cell according to claim 9, **characterized in that** an uncontacted, low doped region (28) separates the highly doped silicon layer (20) from the base region (26).

## Revendications

1. Procédé pour la fabrication d'une cellule solaire à contact en face arrière (10) selon lequel un substrat semi-conducteur de la cellule solaire (10) comprend une face arrière (14), en particulier polie ou texturée, et une face avant (16), en particulier texturée, lequel procédé comprend les étapes suivantes : application d'une couche à effet tunnel (18), en particulier comprenant du dioxyde de silicium, sur une surface de la face arrière (14) ou sur une surface de la face avant (16) et une surface de la face arrière (14), et dépôt d'une couche de silicium fortement dopée (20), en particulier sur toute la surface, d'une première polarité sur la couche tunnel (18) de la face arrière (14), **caractérisé en ce que** ce procédé comprend en outre une étape pour l'application d'une couche de précurseur (22) comprenant une substance de dopage, en particulier du phosphore, sur la couche de silicium fortement dopée (20) de la première polarité sur la face arrière (14), une concentration des substances dopantes dans la couche de silicium fortement dopée (20) de la première polarité et de la couche de précurseur (22) étant choisie de telle sorte qu'une quantité de substance dopante de la substance dopante d'une deuxième polarité dans la couche de précurseur (22) est supérieure à la quantité de substance dopante de la substance dopante de la première polarité dans la couche de silicium fortement dopée (20) de la première polarité et que ce procédé comprend une étape pour l'irradiation au rayonnement laser de la face arrière (14) pour générer des zones de base fortement dopées localement (26), la substance de dopage de la deuxième polarité surcompensant la substance de dopage de la première polarité pendant le rayonnement laser et les zones de base fortement dopées localement (26) étant ainsi générées par surcompensation.

2. Procédé selon la revendication 1, **caractérisé en ce que** le dépôt de la couche de silicium fortement dopée (20) de la première polarité comprend le dépôt du silicium non dopé, puis l'introduction d'une substance dopante.

3. Procédé selon au moins une des revendications 1 à 2, **caractérisé en ce que** ce procédé comprend une étape pour l'élimination de la couche tunnel (18), en particulier de dioxyde de silicium, et/ou de la couche de silicium fortement dopée (20) de la première polarité de la face avant (16).

4. Procédé selon au moins une des revendications 1 à 3, **caractérisé en ce que** ce procédé comprend une étape pour l'application d'une couche de précurseur (22) comprenant une substance dopante, en particulier du phosphore, sur la couche de silicium fortement dopée (20) de la première polarité sur la face avant (16).

5. Procédé selon au moins une des revendications 1 à 4, **caractérisé en ce que** ce procédé comprend une étape pour l'élimination sélective de la couche de silicium fortement dopée (20) de la première polarité et/ou de la couche de précurseur (22).

6. Procédé selon au moins une des revendications 1 à 5, **caractérisé en ce que** ce procédé comprend une étape pour l'application d'une couche de passivation (30, 32) sur la surface de la face avant (16) et/ou de la face arrière (14).

7. Procédé selon au moins une des revendications 1 à 6, **caractérisé en ce que** ce procédé comprend une étape pour l'application d'électrodes (34, 36) sur la face arrière (14) de la cellule solaire (10).

8. Procédé selon au moins une des revendications 6 à 7, **caractérisé en ce que** ce procédé comprend une étape pour l'élimination sélective de la couche de passivation (30, 32).

9. Cellule solaire à contact en face arrière (10) fabriquée selon un procédé selon au moins une des revendications 1 à 8, cette cellule solaire (10) comprenant un substrat semi-conducteur (12), en particulier une plaquette de silicium comprenant une face avant (16) et une face arrière (14), laquelle cellule solaire (10) comprend sur la face arrière des électrodes (30) d'une première polarité et des électrodes (32) d'une deuxième polarité, une couche à effet tunnel (18) et une couche de silicium fortement dopée (20) se trouvant sous les électrodes (34) d'une première polarité et les électrodes (36) de la deuxième polarité étant en contact électrique et mécanique direct avec le substrat semi-conducteur (12) dans les zones de base fortement dopées (26), **caractérisée en ce que** les zones de base fortement dopées (26) comprennent des zones surcompensées de manière sélective de la couche de silicium fortement dopée (20).

10. Cellule solaire selon la revendication 9, **caractérisée en ce qu'**une zone faiblement dopée sans contact (28) sépare la couche de silicium fortement dopée (20) de zone de base (26).
